Europäisches Patentamt

European Patent Office

Office européen des brevets

(19)

(11) **EP 1 297 668 B1**

(12) **EUROPÄISCHE PATENTSCHRIFT**

(45) Veröffentlichungstag und Bekanntmachung des Hinweises auf die Patenterteilung:
**16.11.2005 Patentblatt 2005/46**

(21) Anmeldenummer: **01953137.5**

(22) Anmeldetag: **29.06.2001**

(51) Int Cl.⁷: **H04L 25/03**

(86) Internationale Anmeldenummer:
**PCT/DE2001/002464**

(87) Internationale Veröffentlichungsnummer:
**WO 2002/003637 (10.01.2002 Gazette 2002/02)**

(54) **VITERBI-ENTZERRER DER VERSCHIEDENE HARDWARE-DATENPFADE FÜR ACS-OPERATIONEN UND FÜR ÜBERTRAGUNGSMETRIKEN VERWENDET**

VITERBI EQUALIZER USING VARIOUS HARDWARE DATA PATHS FOR ACS AND TRANSMISSION METRIC OPERATIONS

EGALISEUR DE VITERBI FAISANT INTERVENIR DIFFERENTS CHEMINS DE DONNEES POUR DES OPERATIONS ACS ET DE METRIQUE DE TRANSMISSION

(84) Benannte Vertragsstaaten:
**DE FR GB IT**

(30) Priorität: **03.07.2000 DE 10032237**
**06.06.2001 DE 10127348**
**13.06.2001 DE 20109857 U**

(43) Veröffentlichungstag der Anmeldung:
**02.04.2003 Patentblatt 2003/14**

(73) Patentinhaber: **Infineon Technologies AG**
**81669 München (DE)**

(72) Erfinder: **BECKER, Burkhard**
**85737 Ismaning (DE)**

(74) Vertreter: **Lange, Thomas et al**
**Patentanwälte**
**Lambsdorff & Lange,**
**Dingolfinger Strasse 6**
**81673 München (DE)**

(56) Entgegenhaltungen:
**EP-A- 0 632 623          US-A- 5 502 735**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Viterbi-Entzerrer zur Entzerrung einer über einen gestörten Kanal übertragenen Symbolfolge.

Im Bereich des Mobilfunks müssen über die Luftschnittstelle übertragene Datensignale einer adaptiven Entzerrung unterzogen werden. Ursache hierfür ist, dass sich die Eigenschaften des physikalischen Übertragungskanals bedingt durch Beugung, Streuung und Reflexion der gesendeten Signale ständig ändern.

Es ist bereits bekannt, zur Entzerrung der empfangenen Signale Viterbi-Entzerrer einzusetzen. Viterbi-Entzerrer sind rekursive MLSE-(Maximum-Likelihood Sequence Estimation-)Folgenschätzer. Die Folgenschätzung beruht auf dem Auffinden eines kürzesten Wegs durch ein Trellis-Diagramm, d.h. durch ein Diagramm, in welchem Kanalzustände über der diskreten Zeit aufgetragen sind. Dabei wird gemäß dem Viterbi-Algorithmus für jeden Übergang zwischen einem bestimmten Zielzustand in einem betrachteten Zeitschritt und den möglichen Vorgänger-Zuständen im vorangegangen Zeitschritt eine Übergangsmetrik berechnet, welche ein Maß für die Wahrscheinlichkeit dieses Übergangs darstellt. Nachfolgend werden die Übergangsmetriken den jeweiligen Zustandsmetriken der Vorgänger-Zustände hinzuaddiert (sogenannte "ADD"-Operationen) und es werden die auf diese Weise erhaltenen Summen verglichen (sogenannte "COMPARE"-Operationen). Derjenige Übergang, dessen Summe aus Übergangsmetrik und Metrik des Vorgänger-Zustands minimal ist, wird ausgewählt (sogenannte "SELECT"-Operationen) und bildet die Verlängerung des bis dahin ermittelten Pfades in den Zielzustand. Diese drei Operationen werden als ACS-Operationen bezeichnet.

Da jedem Übergang zwischen einem Vorgänger-Zustand und einem Zielzustand ein den Übergang bewirkendes Datensymbol zugeordnet ist, ist mit dem Auffinden des kürzesten Pfades durch das Trellis-Diagramm auch die Folge der gesendeten Datensymbole ermittelt.

Eine bereits bekannte Erweiterung des Viterbi-Algorithmus (VA) besteht darin, zusätzlich zu der Erzeugung solcher "hart entschiedenen" Datensymbole auch eine Zuverlässigkeitsinformation auszugeben, welche die Sicherheit der gefällten harten Entscheidung angibt und somit in nachfolgenden Dekodierern vorteilhaft ausgenutzt werden kann. Eine solche Ausgabe wird als Soft-Output bezeichnet.

Bei einem Viterbi-Algorithmus, der von einem reduzierten Trellis-Diagramm ausgeht (d.h. ein Trellis-Diagramm, in welchem nur ein Teil der möglichen Kanalzustände berücksichtigt sind) muß außerdem eine Neuberechnung des Zielzustands nach Auffinden des zu ihm führenden Übergangs durchgeführt werden.

In der Schrift EP 0 632 623 A2 ist ein adaptiver Folgenschätzer beschrieben, welcher nach dem Viterbi-Algorithmus arbeitet. Der Folgenschätzer umfasst eine Einheit zum Berechnen der Übergangsmetrikwerte, die aus vier hintereinander geschalteten Hardware-Datenpfaden aufgebaut ist.

In der Schrift US 5,502,735 ist ein Folgenschätzer beschrieben, welcher einen Hardware-Datenpfad zur Durchführung von ACS-Operationen, einen Hardware-Datenpfad zur Berechnung von Übergangsmetriken und einen Datenpfad zur Berechnung von Soft-Output-Werten umfasst. Sämtliche Datenpfade sind für die Prozessierung von 2-wertigen Symbolen ausgeführt.

Für höherstufige Datensignale erhöht sich der Rechenaufwand eines Viterbi-Entzerrers drastisch. Während GSM (Global System for Mobile Communications) ein zweistufiges Datensignal nutzt, liegt dem neuen EDGE-(Enhanced Data Services for GSM Evolution-)Standard das 8PSK-(Phase Shift Keying-)Modulationsverfahren zugrunde, welches ein 8-stufiges Datensignal voraussetzt. Dies bedeutet, dass von jedem Trellis-Zustand 8 (GSM: lediglich 2) Zustands-Übergänge ausgehen und in jedem Trellis-Zustand 8 (GSM: lediglich 2) Zustands-Übergänge enden.

Die ACS-Operationen bei der Abarbeitung des Viterbi-Algorithmus können in einem geeignet programmierten DSP (Digital Signal Processor) durchgeführt werden. Nachteilig ist dabei jedoch, dass eine hohe Rechenleistung verlangt wird, die in der Größenordnung von 400 MIPS (Million Instructions Per Second) und mehr liegt. Neben dem Nachteil, dass derartige Rechenleistungen nur von teuren Prozessoren erreicht werden, tritt im Mobilfunkbereich das besondere Problem hinzu, dass hohe Rechenleistungen stets einen hohen Leistungsverbrauch verursachen. Dies ist aufgrund der beschränkten Energieresourcen in Mobilfunktelefonen jedoch nicht akzeptabel.

Der Erfindung liegt daher die Aufgabe zugrunde, einen Viterbi-Entzerrer zu schaffen, bei welchem rechenintensive Abarbeitungsschritte möglichst resourcenschonend ausgeführt werden. Insbesondere soll der Viterbi-Entzerrer zur Entzerrung von Datensymbolen nach dem EDGE-Standard geeignet sein.

Die der Erfindung zugrunde liegende Aufgabenstellung wird durch die Merkmale des Anspruchs 1 gelöst.

Vorzugsweise weist der Viterbi-Entzerrer einen Hardware-Datenpfad auf, welcher Soft-Output-Werte für die zu schätzende Symbolfolge aus den zu den Zielzuständen führenden Zustandsübergängen berechnet. Hier wird durch die Unterstützung der Viterbi-Entzerrung durch einen weiteren Hardware-Datenpfad eine effektive Entlastung des digitalen Signalprozessors erreicht.

Eine vorteilhafte Ausführungsvariante der Erfindung kennzeichnet sich dadurch, dass die jeweiligen Hardware-Datenpfade direkt, d.h. ohne eine Zwischenverarbeitung der im jeweils vorgeordneten Hardware-Datenpfad berechneten Daten im digitalen Signalprozessor, miteinander in Verbindung stehen. In diesem Fall findet eine direkte übertragung der in dem Hardware-Datenpfad zur Berechnung von Übergangsmetriken berechneten Übergangsmetriken in den Hardware-Datenpfad zur Durchführung von ACS-Operationen bzw. eine direkte Übergabe von in dem Hardware-Datenpfad zur Durchführung von ACS-Operationen berechneter Daten zu dem Hardware-Datenpfad für die Berechnung von Soft-Output-Werten statt. Der digitale Signalprozessor wird hier also nicht zur Durchführung von Zwischenberechnungsschritten benötigt, wodurch Abarbeitungszeit und Rechenleistung eingespart werden können. In bezug auf die Datenpfade besteht die Aufgabe des digitalen Signalprozessors dann lediglich darin, eine geeignete Ablaufsteuerung bzw. zeitliche Koordinierung der betrachteten Datenpfade vorzusehen.

Eine besonders bevorzugte Ausgestaltung der Erfindung besteht darin, dass beide Datenpfade zur Durchführung sowohl einer Entzerrung nach dem EDGE-Mobilfunkstandard als auch einer Entzerrung nach dem GSM-Mobilfunkstandard ausgelegt sind.

Dies bedeutet, dass sowohl GMSK-modulierte 2-stufige Datensymbole als auch 8PSK-modulierte 8-stufige Datensymbole in den jeweiligen Hardware-Datenpfaden verarbeitet werden können. Folglich ist der Viterbi-Entzerrer wahlweise nach dem EDGE- oder dem GSM-Standard betreibbar.

Zur weiteren Entlastung des digitalen Signalprozessors ist zusätzlich zu dem erfindungsgemäß vorgesehenen Hardware-Datenpfad zur Berechnung von Zusatzinformation zu Zielzuständen (Zielzustandsvektoren) im Trellis-Diagramm ein Hardware-Datenpfad zur Berechnung von entschiedenen Datensymbolen vorgesehen.

Eine besonders bevorzugte Ausführung des ersten Hardware-Datenpfads zur Durchführung von ACS-Operationen kennzeichnet sich dadurch, dass dieser eine erste Minimierungsstufe aufweist, in welcher das Minimum der Summen aus Metrik- und Übergangsmetrik von zumindest zwei Zustandsübergängen bestimmt wird, und eine der ersten Minimierungsstufe nachgeschaltete zweite Minimierungsstufe aufweist, welche in sequentieller Verarbeitung das Minimum der von der ersten Minimierungsstufe ausgegebenen Summen bestimmt. Auf diese Weise wird eine teilweise parallele und teilweise sequentielle Durchführung des "COMPARE"-Schritts der ACS-Operation erreicht, welcher sowohl den Vergleich von zwei Zustandsübergängen (bei GSM) als auch den Vergleich von acht Zustandsübergängen (bei EDGE) unterstützt.

Weitere vorteilhafte Ausgestaltungen der Erfindung sind in den Unteransprüchen angegeben.

Die Erfindung wird nachfolgend anhand der Zeichnung unter Bezugnahme auf ein Ausführungsbeispiel erläutert. In diesem zeigt:

Fig. 1    einen Ausschnitt aus einem Trellis-Diagramm von zwei aufeinanderfolgenden Zeitschritten k-1 und k für die EDGE-Entzerrung;

Fig. 2    die Architektur einer Empfängerschaltung, welche einen erfindungsgemäßen Viterbi-Entzerrer enthält;

Fig. 3    eine schematische Darstellung der Hardware-Datenpfade des erfindungsgemäßen Viterbi-Entzerrers;

Fig. 4    ein Blockschaltbild eines Rechenwerks, welches einen Datenpfad für die Berechnung von Übergangsmetriken realisiert;

Fig. 5    ein Blockschaltbild eines Rechenwerks, welches einen Datenpfad zur Durchführung von ACS-Operationen realisiert;

Fig. 6    ein Blockschaltbild eines Rechenwerks, welches einen Datenpfad für die Berechnung von Soft-Output-Werten realisiert;

Fig. 7    ein Blockschaltbild eines Rechenwerks zur Berechnung von hart entschiedenen Datensymbolen; und

Fig. 8    ein Blockschaltbild eines Rechenwerks, welches einen Datenpfad für die Berechnung eines neuen Zustandsvektors realisiert.

Vor der Beschreibung eines Ausführungsbeispiels eines erfindungsgemäßen Viterbi-Entzerrers wird zum besseren Verständnis zunächst das Prinzip der Viterbi-Entzerrung kurz erläutert.

Gemäß bekanntem Ersatzschaltbild kann der zeitvariante Mobilfunkkanal durch ein Schieberegister mit v Speicherzellen, v+1 Abgriffen vor, zwischen und hinter den Speicherzellen, Multiplizierer zur Multiplikation der an den Abgriffen bereitstehenden Datensymbole mit zeitvarianten Kanalparametern (v+1 Stück) und einen ausgangsseitigen Addierer modelliert werden. Die Anzahl v der Speicherzellen wird als Kanalgedächtnis bezeichnet.

In diesem Kanalmodell ist der momentane Zustand des Kanals eindeutig durch die Belegung des Schieberegisters beschrieben. Bei 8PSK-Datensymbolen existieren $8^v$ mögliche Kanalzustände (Belegungen des Schieberegisters), bei GMSK-Datensymbolen sind es lediglich $2^v$.

Ein Zustands-Diagramm des Kanals, in welchem Kanalzustände über der diskreten Zeit kT aufgetragen sind, wird Trellis-Diagramm genannt. T bezeichnet die Symbolzeitdauer und k den Index des betrachteten Zeitschrittes.

Das Senden eines Datensymbols über den Mobilfunkkanal entspricht im Ersatzschaltbild der Eingabe dieses Datensymbols in das Schieberegister. Der Kanal (das Schieberegister) ändert daraufhin seinen Zustand (seine Belegung), d.h. er geht von seinem bisherigen Zustand (Vorgänger-Zustand) in einen durch das ausgesendete Datensymbol eindeutig bestimmten Zustand (Zielzustand) über.

Eine ausgesendete Datensymbolfolge gibt somit einen Weg durch das Trellis-Diagramm vor. Dieser Weg wird auch als der kürzeste Weg durch das Trellis-Diagramm bezeichnet, weil für ihn die Minimumbedingung

$$\sum_{k=0}^{L+v}\left(x_k - \sum_{l=0}^{v} a_{k-l}h_l\right)^2 = \text{Minimum} \qquad (1)$$

gilt. Dabei bezeichnen $x_k$ die vom Empfänger empfangenen Datensymbole, $h_0$, $h_1$, .., $h_v$ die Kanalimpulsantworten des Übertragungskanals, $a_k$ die gesendeten Datensymbole und L+1 die Länge (Anzahl der Elemente) der gesendeten Datensymbolfolge.

Die ausgesendete Datensymbolfolge bzw. der durch diese bestimmte kürzeste Weg durch das Trellis-Diagramm sind im Empfänger unbekannt. Sobald allerdings der kürzeste Weg durch das Trellis-Diagramm empfängerseitig ermittelt ist, ist auch die Folge der ausgesendeten Datensymbole bestimmt. Der Viterbi-Algorithmus beruht auf der schrittweisen, rekursiven Ermittlung dieses kürzesten Weges durch das Trellis-Diagramm.

Allgemein werden beim Viterbi-Algorithmus für jeden Zielzustand zum Zeitschritt k die jeweils möglichen Vorgänger-Zustände zum Zeitschritt k-1 bestimmt (das sind diejenigen Zustände, die durch Senden eines Datensymbols in den betrachteten Zielzustand übergehen können), und es wird für jeden dieser Zustandsübergänge eine Übergangsmetrik berechnet. Die Übergangsmetriken werden dann den (bereits im vorhergehenden Rekursionsschritt berechneten) Metriken der betreffenden Vorgänger-Zustände hinzuaddiert, und die so gebildeten Summen aus Metrik und Übergangsmetrik werden untereinander verglichen. Als Metrik des Zielzustandes wird die kleinste dieser Summen bestimmt, und durch diese Wahl steht dann auch der entsprechende Vorgänger-Zustand und der zugehörige Zustandsübergang fest. Nur dieser Weg durch das Trellis-Diagramm "überlebt" und wird in den Zielzustand fortgesetzt, die anderen Wege brechen ab.

Bei der Viterbi-Entzerrung von höherstufigen Signalen, z.B. 8PSK-modulierten Signalen des EDGE-Standards, wird ein reduziertes Trellis-Diagramm benutzt, da andernfalls der Rechenaufwand nicht zu bewältigen wäre. Beim 8PSK-Modulationsverfahren umfasst das Modulationsalphabet 8 Datensymbole, was zur Folge hätte, dass bei einer Kanalgedächtnislänge von z.B. v = 6 pro Zeitschritt für jeden Zielzustand ($8^6$ Stück) 8 mögliche Übergänge betrachtet werden müssten, wobei zuvor jeweils noch die möglichen Vorgänger-Zustände bezüglich jedem der $8^6$ Zielzustände zu bestimmen wären. Dies übertrifft bei weitem derzeitig verfügbare Rechenleistungen.

Im folgenden Beispiel wird für eine 8PSK-Modulation von einem (drastisch) reduzierten Trellis-Diagramm ausgegangen, welches nur 8 Zustände berücksichtigt. Somit sind für jeden Zeitschritt lediglich 64 Übergangsmetriken (8 Zielzustände, jeweils erreichbar über 8 Übergänge) zu berechnen.

Die 8PSK-Datensymbole werden mit PSK0, PSK1, PSK2, .., PSK7 bezeichnet. Ihre Definition lautet bekanntlich: PSKi = exp (j*i*2π/8), i = 0,..,7; j ist die imaginäre Einheit.

Jeder Zustand des Kanals kann mit dem zuletzt in der eingangsseitigen Speicherzelle des Schieberegisters abgespeicherten Datensymbol identifiziert werden. Er enthält ferner für v = 6 die Information über die letzten fünf Vorgänger-Zustände. Ein Kanalzustand kann demnach durch einen 6-komponentigen Zustandsvektor angegeben werden:

PSKe, PSKd, PSKc, PSKb, PSKa, PSKp

wobei a,b,c,d,e,p = 0,..,7. Dabei wird zur Vereinfachung der Notation der Index k zur Angabe des Zeitschrittes fortgelassen. Die Unterstreichung verdeutlicht das den Zustand bestimmende, zuletzt erhaltene Datensymbol PSKp, die fünf nicht unterstrichen, zuvor erhaltenen Datensymbole können als Zusatz-Information zu diesem Zustand aufgefaßt werden, welche, wie im folgenden noch erläutert, nur bei der Berechnung der Übergangsmetrikwerte eine Rolle spielt.

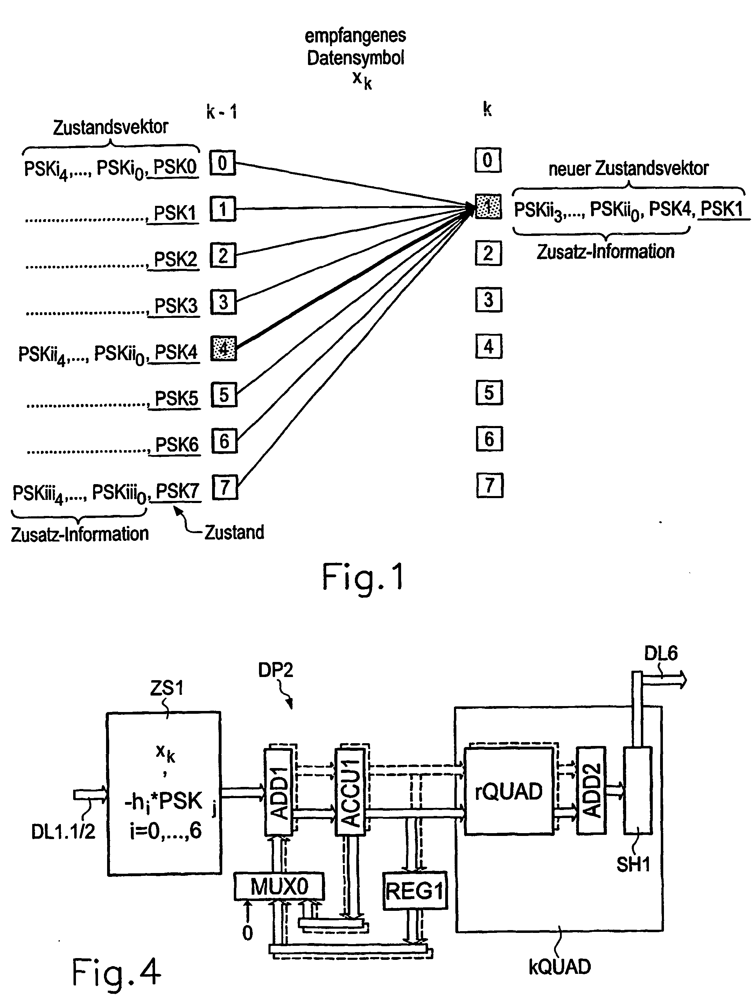

In Fig. 1 sind die acht Zustände zum Zeitschritt k-1 und die acht Zustände zum Zeitschritt k mittels von 0 bis 7 durchnumerierter Kästchen veranschaulicht. Diese Zustandsnummern werden als Indizes der Zustände bezeichnet. Ferner sind die Zustandsvektoren der Zustände zum Zeitschritt k-1 angegeben. Beispielsweise wurde der Zustand mit Index 4 (entspricht PSK4) im Zeitschritt k-1 über die Vorgänger-Zustände $PSKii_0$, $PSKii_1$, $PSKii_2$, $PSKii_3$, $PSKii_4$ erreicht, d.h. der Zustandsvektor dieses Zustands lautet:

$PSKii_4$, $PSKii_3$, $PSKii_2$, $PSKii_1$, $PSKÜ_0$, <u>PSK4</u>

In Fig. 1 sind die Übergänge von sämtlichen Zuständen zum Zeitschritt k-1 zu einem bestimmten Zielzustand zum Zeitschritt k, nämlich dem Zustand mit dem Index 1, eingezeichnet. Die Zusatz-Information zu dem Zielzustand mit Index 1 zum Zeitschritt k ist abhängig von dem jeweils betrachteten Übergang, weil dieser die Zusatz-Information für diesen Zustand bestimmt. Für den mit einem dicken Pfeil kenntlich gemachten Übergang vom Zustand mit Index 4 zum Zeitschritt k-1 zum Zustand mit Index 1 zum Zeitschritt k lautet die Zusatz-Information $PSKii_3$, $PSKii_2$, $PsKii_1$, $PsKii_0$, PSK4.

Ein Zustandsvektor zum Zustand mit Index m im Zeitschritt k wird im folgenden durch $Z_k(m)$ abgekürzt.

Die Übergangsmetrik für den betrachteten Zustandsübergang vom Vorgänger-Zustand mit Index 4 (Zeitschritt k-1) zum Zielzustand mit Index 1 (Zeitschritt k) berechnet sich aus dem Euklidschen Abstand zwischen dem empfangenen Datensymbol $x_k$ und dem Faltungsprodukt aus geschätzten Kanalimpulsantworten und den diesem Vorgänger-Zustand zugeordneten 8PSK-Symbolen (6 Stück) sowie dem Übergangs-Datensymbol (hier: PSK1):

$$I_k(4{\rightarrow}1) = (x_k - \sum_{j=0,1,2,3,4} PSKii_j * h_{j+2} - PSK4 * h_1 - PSK1 * h_0)^2 \quad (2)$$

Die Übergangsmetriken $I_k(m{\rightarrow}1)$ bezüglich der Übergänge von den anderen möglichen Vorgänger-Zuständen m = 0,1,2,3,5,6,7 zum Zeitschritt k-1 zu dem bestimmten Zielzustand mit dem Index 1 zum Zeitschritt k berechnen sich in analoger Weise. Die Schreibweise $I_k(m{\rightarrow}m')$ soll im folgenden allgemein die Übergangsmetrik für einen Zustandsübergang vom Zustand m zum Zeitschritt k-1 in den Zielzustand m' zum Zeitschritt k bezeichnen, m' = 0,..,7.

Die Metriken der Zustände m = 0,..,7 zum Zeitschritt k werden mit $M_k(m)$ bezeichnet. Im dargestellten Rekursionsschritt des Viterbi-Algorithmus für den k-ten Zeitschritt sind alle Metriken $M_{k-1}(m)$ bekannt und die Metriken $M_k(m)$ zu berechnen.

Entsprechend den vorhergehenden allgemeinen Erläuterungen werden bei dem Additionsschritt ("ADD") der ACS-Operation nun die berechneten Übergangsmetriken $I_k(m{\rightarrow}m')$ zu den bereits berechneten Metriken $M_{k-1}(m)$ der Vorgänger-Zustände hinzuaddiert, d.h. für den Zielzustand m = 1 zum Zeitschritt k die Summe $M_{k-1}(m) + I_k(m{\rightarrow}1)$ gebildet. Beim Vergleichsschritt ("COMPARE") wird diejenige Summe mit dem kleinsten Wert gefunden und als Metrik $M_k(1)$ des Zielzustands bestimmt. Im betrachteten Fall soll dies der Metrikwert sein, der sich bei dem fett eingezeichneten Übergang vom Zustand mit Index 4 zum Zeitschritt k-1 zum betrachteten Zielzustand 1 zum Zeitschritt k ergibt. Mit der Auswahl dieses wahrscheinlichsten Vorgänger-Zustands mit Zustandsvektor $PSKii_4$,.., $PSKii_0$,<u>PSK4</u> kann der neue Zustandsvektor des Zustandes mit Index 1 zum Zeitschritt k aufgebaut werden. Er lautet:

$PSKii_3$, $FSKii_2$, $PSKii_1$, $PSKii_0$, PSK4, <u>PSK1</u>

Nach der Durchführung der ACS-Operationen zu sämtlichen Zuständen im Zeitschritt k sind auch sämtliche Zustandsvektoren (8 Stück) für diese Zustände ermittelt.

In dem dargestellten Beispiel sind Übergänge zwischen sämtlichen Zuständen möglich. Dies ergibt sich zwingend aus der Tatsache, dass bei einem 8-stufigen Symbolalphabet acht Übergänge zu jedem Zielzustand hinführen und in dem hier betrachteten reduzierten Trellis-Diagramm nur acht Kanalzustände berücksichtigt werden. Die Wahl eines reduzierten Trellis-Diagramms mit nur 8 Zuständen ist jedoch keine Voraussetzung für die Erfindung, möglich ist auch die Abarbeitung des Viterbi-Algorithmus unter Zugrundelegung eines weniger stark reduzierten Trellis-Diagramms mit mehr als 8 Zuständen.

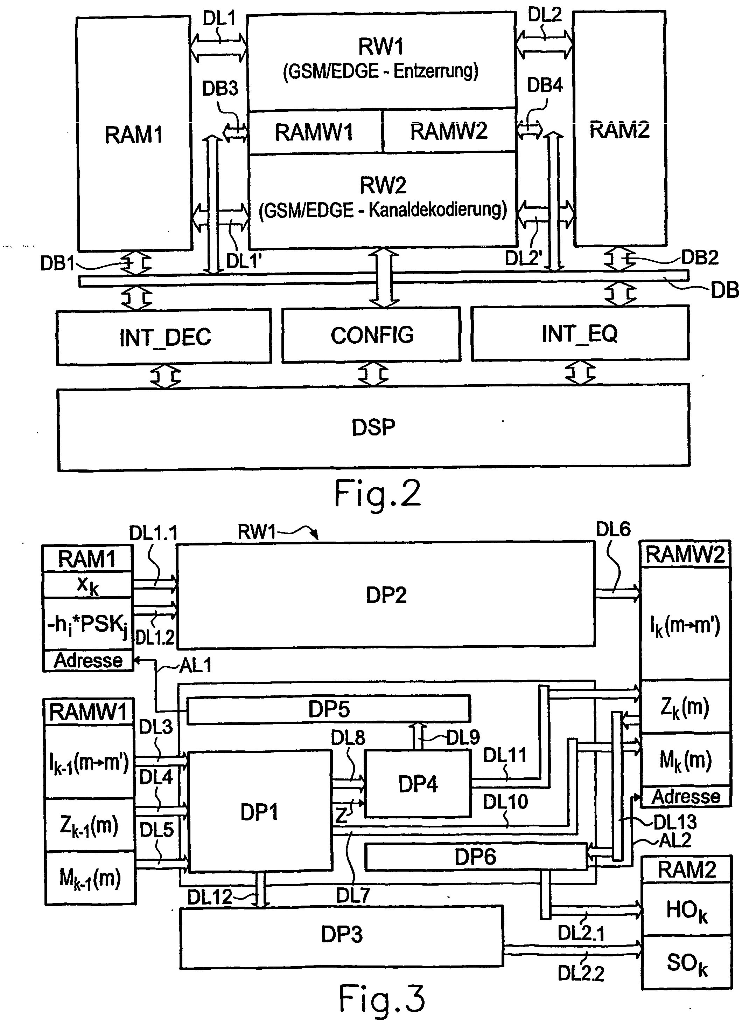

Fig. 2 zeigt die Architektur einer Empfängerschaltung mit einem erfindungsgemäßen Entzerrer in Form von Funktionsblöcken und Datenverbindungen (Datenbussen) zwischen den Funktionsblöcken. Zentraler Bestandteil der Schaltung ist ein digitaler Signalprozessor DSP, der über ein oder mehrere Konfigurationsregister CONFIG mit zwei Rechenwerken RW1 und RW2 in Datenaustauschverbindung steht. Das erste Rechenwerk RW1 dient der Entzerrung eines empfangenen Datensignals, d.h. es macht die Signalverzerrungen rückgängig, die bei der senderseitigen Modulation und Übertragung des modulierten Signals über die Luftschnittstelle aufgetreten sind. Das zweite Rechenwerk RW2 führt eine Kanaldekodierung durch, d.h. in dieser Schaltung wird die Redundanz entfernt, welche bei der senderseitigen Kanalkodierung dem gesendeten Signal vor der Modulation auf einen geeigneten Träger hinzugefügt wurde. Die Rechenwerke RW1 und RW2 können eine Entzerrung beziehungsweise Kanaldekodierung sowohl z.B. gemäß dem GSM- als auch gemäß dem EDGE-Standard ausführen.

Das erste Rechenwerk RW1 steht über eine erste bidirektionale Datenverbindung DL1 mit einem ersten flüchtigen Datenspeicher RAM1 und über eine zweite bidirektionale Datenverbindung DL2 mit einem zweiten flüchtigen Datenspeicher RAM2 in Datenaustauschverbindung. Entsprechende dritte und vierte bidirektionale Datenverbindungen DL1', DL2' sind zwischen dem zweiten Rechenwerk RW2 und dem ersten Datenspeicher RAM1 sowie dem zweiten Rechenwerk RW2 und dem zweiten Datenspeicher RAM2 vorgesehen.

Das erste Rechenwerk RW1 steht in noch näher zu beschreibender Weise mit zwei flüchtigen Datenspeichern RAMW1 und RAMW2 in Verbindung. Auch das zweite Rechenwerk RW2 greift auf die Datenspeicher RAMW1 und RAMW2 zu. Alle internen Datenspeicher RAM1, RAM2, und RAMW1, RAMW2 sind zum Zwecke der Programmierung der Rechenwerke RW1, RW2 und der Initialisierung vom digitalen Signalprozessor DSP aus beschreibbar und auch lesbar. Der Zugriff vom DSP erfolgt über zwei Schnittstellen INT_DEC und INT_EQ, über einen zentralen Datenbus DB und über die internen Datenbusse DB1 (RAM1), DB2 (RAM2), DB3 (RAMW1) und DB4 (RAMW2). Die Schnittstelle INT_DEC ist für den Zugriff des DSPs während eines Kanaldekodiervorgangs und die Schnittstelle INT_EQ ist für den Zugriff des DSPs während eines Entzerrungsvorgangs bestimmt.

Die Rechenwerke RW1, RW2, die Datenspeicher RAM1, RAM2, RAMW1 und RAMW2 sowie die Datenbusse DB3, DB4 und die Datenverbindungen DL1, DL2, DL1', DL2' können konstruktiv in Form eines separaten Arithmetik-Prozessors zusammengefaßt sein.

Aufbau und Arbeitsweise des hier nicht näher dargestellten zweiten Rechenwerks RW2 zur Durchführung einer Kanaldekodierung sind in der deutschen Patentanmeldung DE 100 64 102.4 beschrieben, welche durch Bezugnahme dem Offenbarungsgehalt der vorliegenden Schrift hinzugefügt wird.

Fig. 3 zeigt den Aufbau des ersten Rechenwerks RW1. Dieses umfasst die folgenden schnellen Hardware-Datenpfade:

- Datenpfad zur Durchführung der ACS-Operationen DP1
- Datenpfad zur Berechnung von Übergangsmetriken DP2
- Datenpfad zur Berechnung von Soft-Output-Werten DP3
- Datenpfad zur Berechnung neuer Zustandsvektoren DP4
- Datenpfad zur Berechnung von Adressen für Partialsummanden für Übergangsmetriken DP5, und
- Datenpfad zur Berechnung von hart entschiedenen Datensymbolen DP6

Ferner sind in Fig. 3 die Speicherinhalte der Datenspeicher RAM1, RAM2, RAMW1 und RAMW2 dargestellt und es sind die Datenverbindungen gezeigt, welche die Speicher RAM1/2, RAMW1/2 mit den Datenpfaden DP1-6 sowie die Datenpfade DP1-6 untereinander verbinden.

Der Datenspeicher RAM1 stellt den Eingabe-Datenspeicher für den Datenpfad DP2 zur Berechnung von Übergangsmetriken dar. Er enthält einen ersten Speicherbereich, in welchem die empfangenen Datensymbole $x_k$ abgelegt sind, und einen zweiten Speicherbereich, in welchem Produkte aus Kanalimpulsantworten und 8PSK-Datensymbolwerten abgelegt sind. Anstelle einzelner Produkte können auch Partialsummanden der Übergangsmetrikwerte bestehend aus zwei oder mehr derartiger Produkte in dem Datenspeicher RAM1 abgelegt sein.

Die Speicher RAMW1 und RAMW2 weisen jeweils drei Speicherabschnitte auf, welche Übergangsmetriken, Zustandsvektoren und Metriken enthalten. Dabei enthält der Datenspeicher RAMW1 die Werte $I_{k-1}$ (m→m'), $Z_{k-1}(m)$ und $M_{k-1}(m)$ für den bereits abgearbeiteten Zeitschritt k-1 (d.h. die "alten" Werte), während dem Datenspeicher RAMW2 die entsprechenden neu berechneten Werte $I_k(m→m')$, $Z_k(m)$ und $M_k(m)$ eingegeben werden.

Der Datenspeicher RAM2 dient als Ausgabe-Datenspeicher des Rechenwerks RW1 und speichert in einem ersten Abschnitt Hard-Output-Werte $HO_k$ (sogenannte hart entschiedene Datensymbole) und in einem zweiten Abschnitt Soft-Output-Werte $SO_k$ (d.h. Zuverlässigkeitsinformation).

Empfangene Datensymbole $x_k$ werden dem zweiten Datenpfad DP2 über eine Datenverbindung DL1.1 von dem Datenspeicher RAM1 zugeleitet, die Ausgabe der in dem zweiten Datenpfad DP2 berechneten Übergangsmetriken $I_k(m→m')$ erfolgt über eine zweite Datenverbindung DL6. Zur Verbindung der Speicherabschnitte des Datenspeichers RAMW1 mit dem ersten Datenpfad DP1 sind Datenverbindungen DL3, DL4, DL5 vorgesehen. Der erste Datenpfad DP1 berechnet neue Metriken und stellt diese dem entsprechenden Abschnitt des Datenspeicher RAMW2 über eine Datenverbindung DL10 zur Verfügung. Ferner ist der erste Datenpfad DP1 ausgangsseitig über eine Datenverbindung DL7 mit dem sechsten Datenpfad DP6 und über eine Datenverbindung DL8 und eine Zeigerinformation Z mit dem vierten Datenpfad DP4 verbunden.

Eine Datenverbindung DL9 verbindet den vierten Datenpfad DP4 ausgangsseitig mit dem fünften Datenpfad DP5. Der fünfte Datenpfad DP5 erzeugt Adressen, welche über eine Adressverbindung AL1 einem Adressdekoder des Datenspeichers RAM1 zugeleitet werden. Die Adressen rufen im zweiten Abschnitt von RAM1 abgelegte und zuvor von dem DSP berechnete Produkte $-h_i^*PSK_j$ auf, welche daraufhin über eine Datenverbindung DL1.2 in den zweiten Datenpfad DP2 geladen werden.

Über eine Datenverbindung DL10 werden von dem ersten Datenpfad DP1 neu berechnete Metriken $M_k(m)$ dem entsprechenden Speicherabschnitt des Datenspeichers RAMW2 zugeleitet. Eine Datenverbindung DL11 dient zur Übermittlung von in dem vierten Datenpfad DP4 berechneten neuen Zustandsvektoren zu dem entsprechenden Abschnitt des Datenspeichers RAMW2. Ferner hat der sechste Datenpfad DP6 über eine Datenverbindung DL13 Zugriff auf die neu berechneten Zustände $Z_k(m)$.

Die von dem sechsten Datenpfad DP6 berechneten Hard-Output-Werte $HO_k$ werden dem Datenspeicher RAM2 über eine Datenverbindung DL2.1 zugeleitet, und die in dem dritten Datenpfad DP3 berechneten Soft-Output-Werte $SO_k$ werden über eine Datenverbindung DL2.2 nach RAM2 übertragen.

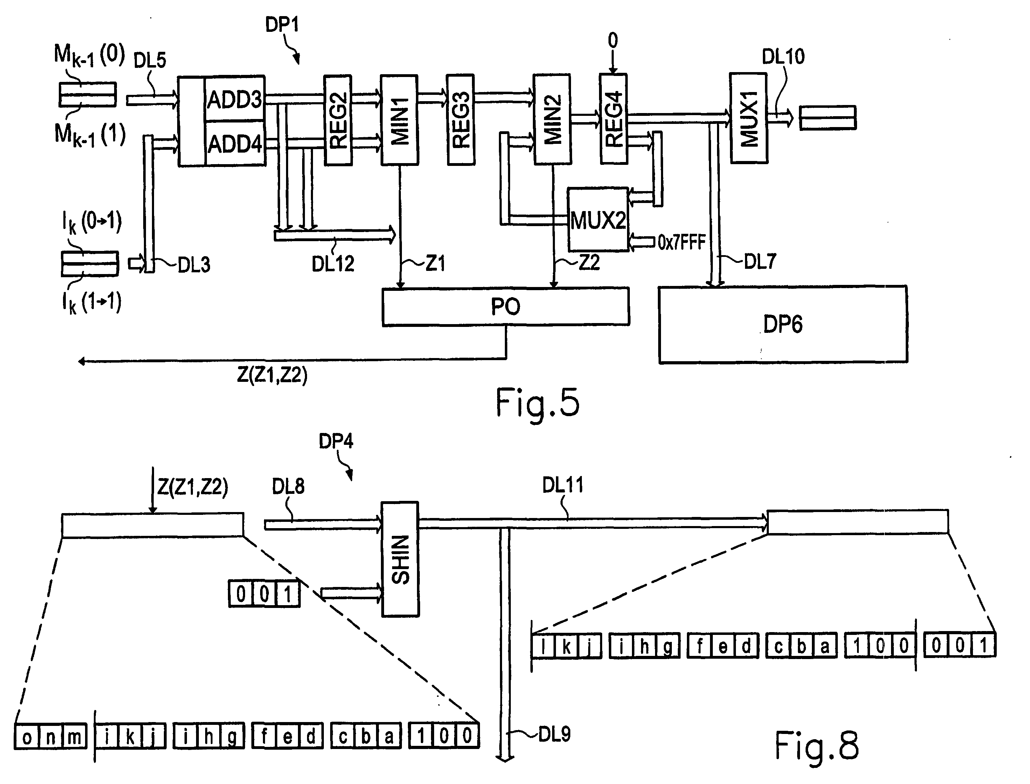

Fig. 4 zeigt ein Blockschaltbild des zweiten Datenpfads DP2 zur Berechnung der Übergangsmetriken. Der Datenpfad umfaßt einen Zwischenspeicher ZS1, einen Addierer ADD1, einen Akkumulator ACCU1, einen temporären Speicher REG1 sowie einen Multiplexer MUX0. Ferner enthält der zweite Datenpfad DP2 eine komplexe Quadriereinheit kQUAD, welche aus zwei reellen Quadrierern rQUAD, einem Addierer ADD2 und einem Shifter SH1 besteht. Der Shifter SH1 ist ausgabeseitig mit der Datenverbindung DL6 verbunden.

Nachfolgend wird die Arbeitsweise des zweiten Datenpfads DP2 beschrieben. Der zweite Datenpfad DP2 berechnet Übergangsmetriken in Vorwärtsrichtung nach der in Gleichung 2 angegebenen Formel. In Vorwärtsrichtung bedeutet, dass von einem bestimmten Vorgänger-Zustand ausgehend zunächst sämtliche Übergangsmetriken (8 Stück) berechnet werden, dann der nächste Vorgänger-Zustand betrachtet wird und von diesem wiederum sämtliche Übergangsmetriken berechnet werden, und so weiter.

Zum besseren Verständnis wird ein bestimmter Vorgänger-Zustand $Z_{k-1}(m)$ mit dem beliebigen Zustandsvektor

PSKg,PSKf,PSKe,PSKd,PSKc,PSKb

herausgegriffen (wobei g,f,e,d,c,b = 0,..,7). Die Produkte dieser Datensymbole mit den zugehörigen Kanalkoeffizienten werden über die Adressverbindung AL1 angewählt und über die Datenverbindung DL1.2 in den Zwischenspeicher ZS1 geladen. Ferner wird das aktuelle Datensymbol $x_k$ in den Zwischenspeicher ZS1 geschrieben.

Gemäß Gleichung 2 sind die acht von dem betrachteten Vorgänger-Zustand ausgehenden Übergangsmetriken durch den Ausdruck

$$|x_k\text{-}PSKg^*h_6\text{-}PSKf^*h_5\text{-}PSKe^*h_4\text{-}PSKd^*h_3\text{-}PSKc^*h_2\text{-}PSKb^*h_1,\text{-}PSKi_a^*h_0|^2$$

bestimmt.

Dabei kann das den jeweiligen Übergang repräsentierende Datensymbol $PSKi_a$ sämtliche mögliche Werte $PSKi_a$, $i_a = 0,..,7$, annehmen. Somit ergibt sich folgender Rechnungsablauf: Bei Anwahl des oben genannten Vorgänger-Zustands werden zunächst die für die Berechnung der ersten Übergangsmetrik benötigten sieben Produkte (mit $\text{-}PSKi_a^*h_0\text{=-}PSK0^*h_0$) im Zwischenspeicher ZS1 zwischengespeichert. Sodann werden mittels des Addierers ADD1 und des Akkumulators ACCU1 die durch den Vorgänger-zustand vorgegebenen ersten sechs Produkte sowie das empfangene Datensymbol $x_k$ addiert (es wird darauf hingewiesen, dass die Produkte bereits mit einem negativen Vorzeichen versehen in dem Speicher RAM1 abgelegt sind, so dass eine Negierung derselben bzw. der Einsatz eines Subtrahierers nicht erforderlich ist), und diese Teilsumme wird anschliessend in dem temporären Speicher REG1 abgespeichert. In einem abschließenden Additionsschritt wird dann das den Übergang bestimmende Produkt $\text{-}PSKi_a^*h_0\text{=-}PSK0^*h_0$ hinzuaddiert und die entsprechende Summe wird dem komplexen Quadrierer kQUAD1 zugeleitet.

Es wird darauf hingewiesen, dass der Addierer ADD1, der Akkumulator ACCU1, der temporäre Speicher REG1 sowie - wie bereits erwähnt - der reelle Quadrierer rQUAD doppelt ausgeführt sind, um eine Verarbeitung von Real- und Imaginärteil der Datensymbole zu ermöglichen. Die doppelte Ausführung dieser Einheiten ist durch die gestrichelten Linien angedeutet.

Die beiden reellen Quadrierer rQUAD nehmen jeweils eine Quadrierung des Real- und des Imaginärteils der erhaltenen Summen vor. Im Addierer ADD2 werden der quadrierte Realteil und der quadrierte Imaginärteil addiert und dem Shifter SH1 zugeleitet. Dieser nimmt eine 1-Bit-Verschiebung des erhaltenen Datenworts vor und gibt dieses dann als erste Übergangsmetrik zum betrachteten Vorgänger-Zustand über die Datenverbindung DL6 aus.

Zur Berechnung der nächsten Übergangsmetrik mit $\text{-}PSKi_a^*h_0\text{=-}PSK1^*h_0$ wird mittels des Multiplexers MUX0 die in dem temporären Speicher REG1 abgelegte Teilsumme dem Addierer ADD1 zugeleitet und dort mit dem Produkt $\text{-}PSK1^*h_0$ des nun zu berechnenden zweiten Übergangs addiert. Die weitere Verarbeitung erfolgt analog der vorhergehenden Beschreibung, und die Ausgabe der berechneten Übergangsmetrik von dem betrachteten Vorgänger-Zustand in den Zielzustand mit m = 1 erfolgt dann wiederum über die Datenverbindung DL6.

Anschließend werden die restlichen sechs Übergangsmetriken zu dem betrachteten Vorgänger-Zustand berechnet. Dann wird zu dem nächsten Vorgänger-Zustand gewechselt und gleichermaßen verfahren.

Es wird deutlich, dass die Berechnung der Übergangsmetriken in Vorwärtsrichtung mittels des zweiten Datenpfads DP2 wesentlich aufwandsgünstiger durchzuführen ist, als eine Berechnung der Übergangsmetriken in Rückwärtsrichtung, wie sie üblicherweise bei der Abarbeitung des Viterbi-Algorithmus stattfindet. Die Ursache hierfür ist darin zu sehen, dass aufgrund der Produkt- oder Teilsummen-Zwischenspeicherung in dem temporären Speicher REG1 für die Berechnung der zweiten bis achten Übergangsmetriken jeweils lediglich ein Speicheraufruf (für $\text{-}PSKi_a^*h_0$) benötigt wird.

Fig. 5 zeigt den Aufbau des ersten Datenpfads DP1 zur Durchführung der ACS-Operationen.

Der Datenpfad DP1 umfaßt eingangsseitig zwei Addierer ADD3, ADD4, deren Addiererausgänge einem temporären Speicher REG2 zugeführt sind. Der temporäre Speicher REG2 ist einer ersten Minimum-Einheit MIN1 vorgeordnet. Über einen weiteren Speicher REG3 wird der Ausgang der ersten Minimum-Einheit MIN1 einer zweiten Minimum-Einheit MIN2 zugeleitet. Der Ausgang der zweiten Minimum-Einheit MIN2 wird einem weiteren temporären Speicher REG4 zugeführt. Der Speicherinhalt von REG4 wird einerseits einem Multiplexer MUX1 zugeleitet und andererseits über einen Multiplexer MUX2 dem zweiten Vergleichseingang der zweiten Minimum-Einheit MIN2 zurückgekoppelt. Ferner umfaßt die Schaltung eine Einheit PO zur Erzeugung eines Zeigers Z(Z1,Z2), welcher aus von den Minimum-Einheiten MIN1, MIN2 ausgegebenen Zeiger-Informationen Z1, Z2 gebildet wird. Die eingangsseitige Datenverbindung DL4 ist mit der ausgangsseitigen Datenverbindung DL8 identisch. Diese Datenverbindungen sind in Fig. 5 nicht dargestellt.

Die Arbeitsweise der in Fig. 5 dargestellten Schaltung ist wie folgt:

Zunächst werden die vom Datenpfad DP2 berechneten Übergangsmetrikwerte von RAMW2 in RAMW1 umgespeichert. Den beiden Addierern ADD3, ADD4 werden dann über die Datenverbindungen DL5 und DL3 jeweils zwei Metriken von Vorgänger-Zuständen und die dazugehörigen zwei (in DP2 gerade neu berechneten) Übergangsmetriken bezüglich eines bestimmten Zielzustands zum Zeitschritt k geliefert. Für das in Fig. 1 dargestellte Beispiel (Zielzustand ist m = 1) sind die entsprechenden Metrik- und Übergangsmetrikwerte für die ersten beiden Übergänge ($0\rightarrow1$ und $1\rightarrow1$) in Fig. 5 angegeben.

Jeder Addierer ADD3 bzw. ADD4 addiert eine Metrik mit der zugehörigen Übergangsmetrik, so dass am Ausgang der Addiererstufe ADD3, ADD4 bei jedem Abarbeitungsschritt zwei entsprechende Summenwerte ausgegeben werden. Beide Summenwerte sind Kandidaten für die zu berechnende minimale Metrik des Zielzustands (m = 1).

Die beiden Summen werden von der ersten Minimum-Einheit MIN1 aus dem temporären Speicher REG2, in welchen sie zuvor abgelegt wurden, abgerufen, und die kleinere der beiden Summen erscheint am Ausgang der ersten Minimum-Einheit MIN1. Die Zeiger-Information Z1 gibt dabei an, welcher der beiden betrachteten Übergänge die minimale Summe zeigt.

Nach Zwischenspeicherung in dem temporären Speicher REG3 wird diese minimale Summe dem einen Eingang der zweiten Mimimum-Einheit MIN2 zugeleitet, während der andere Eingang über den zweiten Multiplexer des MUX2 zunächst auf einen maximal möglichen Wert (bei einer Wortbreite von beispielsweise 16 Bit der Wert 0x7FFF) gesetzt wird. Infolgedessen wird die am Eingang der zweiten Minimum-Einheit MIN2 erhaltene Summe in den temporären Speicher REG4 geschrieben.

Währenddessen werden in den Addierern ADD3, ADD4 bereits die nächsten Summen bezüglich der Übergänge zwischen den Zuständen $2\rightarrow1$ und $3\rightarrow1$ berechnet und in der ersten Minimum-Einheit MIN1 das Minimum dieser Summen bestimmt. Wiederum wird Zeigerinformation Z1 generiert und die kleinere der beiden Summen der zweiten Minimum-Einheit MIN2 zugeführt. Die kleinere der beiden Summen wird nun über den Multiplexer MUX2 mit der zuvor bestimmten minimalen Summe verglichen, welche im temporären Speicher REG4 abgelegt ist. Sodann wird der Speicherinhalt des temporären Speichers REG4 mit dem Ausgang der zweiten Minimum-Einheit MIN2 überschrieben, wobei je nach dem Ergebnis der Minimum-Bildung eine Änderung des Speicherinhalts auftritt oder nicht. Die zweite Zeigerinformation Z2 verwendet den kleineren der beiden verglichenen Summenwerte.

Es wird deutlich, dass nach vier solchen Abarbeitungsschritten die minimale Summe aus den Metriken der Vorgänger-Zustände und den zugehörigen Übergangsmetriken gefunden ist. Der Zeiger Z(Z1,Z2) deutet dabei auf den Zustandsvektor des im Rahmen dieser ACS-Operation ermittelten Vorgänger-Zustands. In Fig. 1 wäre dies der Vektor $PSKii_4$, $PSKii_3$, $PSKii_2$, $PSKii_1$, $PSKii_0$, $\underline{PSK4}$ .

Die auf diese Weise bestimmte Metrik des Zielzustands wird über den Multiplexer MUX1 und die Datenverbindung DL10 in den Datenspeicher RAMW2 geladen.

Fig. 8 zeigt in schematischer Weise den Aufbau des vierten Datenpfades DP4 zur Berechnung des neuen Zustandsvektors. Aufgrund des auf den Zustandsvektor des "richtigen" Vorgänger-Zustands $Z_{k-1}(m)$ (Fig. 1: Zustand mit Index m = 4) deutenden Zeigers Z(Z1,Z2) wird dieser über die Datenverbindung DL4, DL8 aus dem entsprechenden Speicherabschnitt des Datenspeichers RAMW1 aufgerufen. In Fig. 8 ist eine Darstellung dieses Zustandsvektors gewählt, welche berücksichtigt, dass jedes PSK-Datensymbol durch ein Bit-Tripel kodiert ist. Das heisst, der Vorgänger-Zustand besteht aus den in Fig. 8 gezeigten sechs Bit-Tripeln 0nm|1kj|ihg|fed|cba|100.

Dieser Zustandsvektor wird nun einem ersten Eingang eines Schiebe- und Einfüge-Registers SHIN des Datenpfads DP4 zugeführt, während an einem Einschiebe-Eingang dieses Registers SHIN das Bit-Tripel (z.B. 001) anliegt, welches das Übergangs-PSK-Symbol darstellt. Das Schiebe- und Einfüge-Register SHIN nimmt die in Fig. 8 graphisch dargestellte Operation vor, d.h. das "älteste" Bit-Tripel 0nm wird verworfen, die anderen Bit-Tripel werden nach links geschoben und das Übergangs-Bit-Tripel 001 wird an den Anfang des abgespeicherten Bit-Worts gesetzt. Der auf diese Weise gebildete Zustandsvektor des Zielzustands wird über die Datenverbindung DL11 in den entsprechenden Abschnitt des Datenspeichers RAMW2 geschrieben.

Auf der Basis des neu bestimmten Zustandsvektors werden mittels des fünften Datenpfades DP5 die Adres-

EP 1 297 668 B1

sen für den Aufruf der zugehörigen Produkte zur Berechnung von Übergangsmetrikwerten für die nächsten Zustandsübergänge, die von dem gerade berechneten Zustand ausgehen und in Endzuständen des Zeitschrittes k+1 enden, vorgenommen. Hierzu werden im fünften Datenpfad DP5 die im vierten Datenpfad DP4 ermittelten Zustandsvektoren in Einzelkomponenten zerlegt, welche als Adressen auf die im RAM1 abgespeicherten Produkte oder Partialsummanden der von diesem Zustand ausgehenden Übergangsmetriken zu Zuständen des nachfolgenden Zeitschrittes verwendet werden.

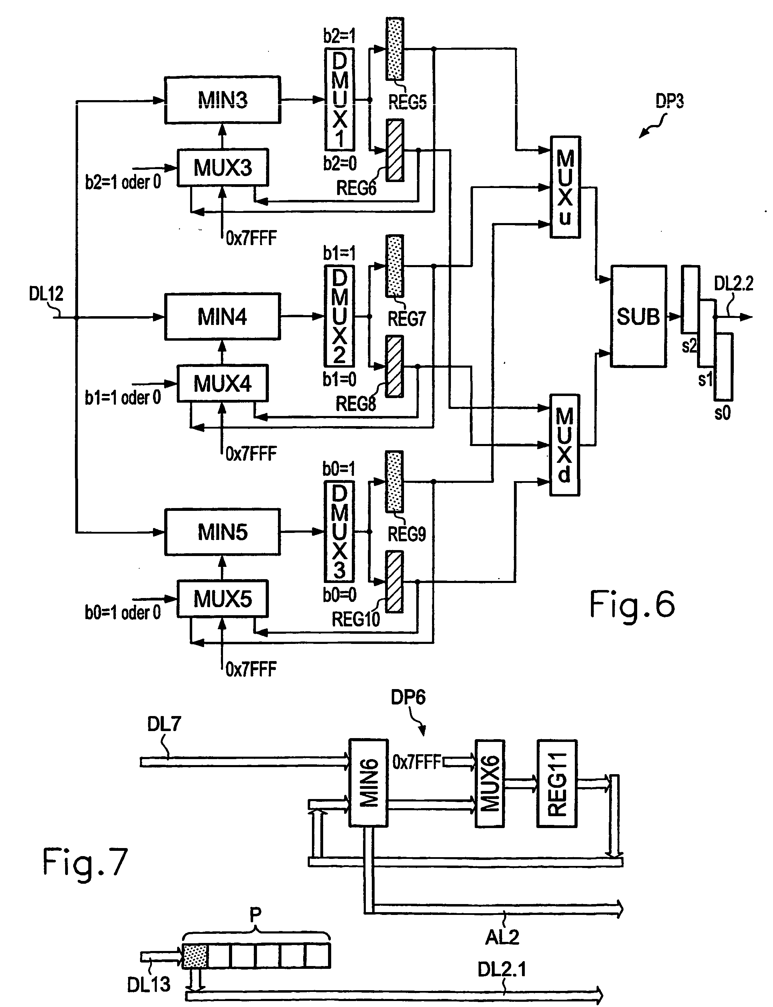

Fig. 6 zeigt den Aufbau des dritten Datenpfads DP3 zur Erzeugung von Soft-Output-Werten. Der dritte Datenpfad DP3 umfaßt drei Minimum-Einheiten MIN3, MIN4, MIN5, denen ausgangsseitig jeweils ein Demultiplexer DMUX1, DMUX2, DMUX3 nachgeschaltet sind. Die Demultiplexer DMUX1-3 nehmen eine Signalaufspaltung jeweils für zwei temporäre Speicher REG5, REG6; REG7, REG8; REG9, REG10 vor. Die beiden Ausgänge jedes Speicherpaars REG5, REG6 bzw. REG7, REG8 bzw. REG9, REG10 sind Multiplexern MUX3, MUX4, MUX5 zugeleitet, welche den jeweils zweiten Eingang der entsprechenden Minimum-Einheit MIN3 bzw. MIN4 bzw. MIN5 bilden.

Ferner stehen die Ausgänge der temporären Speicher REG5, REG7 und REG9 mit den drei Eingängen eines Multiplexers MUXu (das u steht für up) in Verbindung, und die drei Ausgänge der temporären Speicher REG6, REG8, REG10 stehen mit drei Eingängen eines Multiplexers MUXd (d steht für down) in Verbindung.

Die Multiplexer-Ausgänge von MUXu, MUXd werden einem Subtrahierer SUB zugeführt, welcher an seinem Ausgang pro Datensymbol (drei Bits) drei Softbit-Werte s0, s1 und s2 ausgibt.

Die Arbeitsweise des dritten Datenpfads DP3 zur Erzeugung von Soft-Output-Werten ist wie folgt:

Ein 8PSK-Datensymbol wird durch ein Tripel (b0,b1,b2) dargestellt, wobei bi=0 oder 1 für i=0,1,2. Für jeden Zeitschritt wird für jede Komponente bi des 8PSK-Datensymbols ein Konfidenzwert berechnet, welcher angibt, mit welcher Wahrscheinlichkeit die entsprechende Komponente des hart entschiedenen Datensymbols den Wert 1 aufweist. Der Softbit-Wert si zum Bit bi errechnet sich nach der Gleichung

$$\text{si}=\min((M_{k-1}(m)+I_k(m \rightarrow m') \ (bi=1) - (M_{k-1}(m) + I_k(m \rightarrow m') \ |bi=0) \qquad (3)$$

für i= 0,1,2.

Die drei Softbit-Werte bilden den Soft-Output-Wert $SO_k$.

Es wird darauf hingewiesen, dass die Soft-Output-Werte zeitgleich mit der Abarbeitung der ACS-Operationen für den betrachteten Zeitschritt-Übergang berechnet werden. Hierzu werden den Minimum-Einheiten MIN3-5 über die Datenverbindung DL12 ständig die Summen aus alten Metriken und Übergangsmetriken zugeleitet. Die Demultiplexer DMUX1-3 entscheiden, in welchem der sechs temporären Speicher REG5 bis REG10 die an den Ausgängen der Minimum-Einheiten MIN3-5 auftretenden Werte abgespeichert werden sollen. Bei b2=1 erfolgt die Abspeicherung in REG5, bei b2=0 in REG6, bei b1=1 in REG7, bei b1=0 in REG8, bei b0=1 in REG9 und bei b0=0 in REG10. Die abgespeicherten Summen werden dann für den nächsten Vergleichsschritt (welchem ein anderer der 64 Übergänge zwischen zwei benachbarten Zeitschritten zugrundeliegt) in die zugehörige Minimum-Einheit MIN3-5 zurückgekoppelt, wobei die Wahl des jeweiligen Registers (REG5 oder REG6 bzw. REG7 oder REG8 bzw. REG9 oder REG10) von den Multiplexern MUX3-5 je nach Ausprägung der zugehörigen Bit-Komponente b2 bzw. b1 bzw. b0 erfolgt. Bei der ersten Minimum-Bildung pro Zeitschritt wird ein maximaler Vergleichswert (z.B. 0x7FFF) verwendet.

Da für jede Bit-Komponente 32 Übergänge auftreten, erfolgt die Minimierung entsprechend der oben angegebenen Gleichung jeweils über 32 Zustandsübergänge. Nach Abarbeitung sämtlicher Zustandsübergänge zu einem Zeitschritt werden die Soft-Output-Werte für diesen Zeitschritt mittels des Subtrahierers SUB aus den in der beschriebenen Weise rekursiv ermittelten (Metrik+Übergangsmetrik)-Summen berechnet, welche in den temporären Speichern REG5-10 bereitgehalten werden. Hierzu werden die Multiplexer MUXu und MUXd jeweils im Zeitmultiplex betrieben. Die Softbit-Werte s0, s1, s2 sind vorzeichenbehaftete Zweierkomplementwerte, welche über die Datenverbindung DL2.2 dem Datenspeicher RAM2 zugeführt werden.

Fig. 7 zeigt den Aufbau des Datenpfads DP6 zur Berechnung von Hard-Output-Werten. Der Datenpfad DP6 besteht im wesentlichen aus einer Minimum-Einheit MIN6, einem Multiplexer MUX6 und einem temporären Speicher REG11, welche in einer Schleife geschaltet sind. In der für andere Datenpfade bereits beschriebenen Weise ermöglicht die Schleife die Bestimmung des minimalen Werts der über die Datenverbindung DL7 erhaltenen neuen Zustandsmetriken (welche ihrerseits in dem Datenpfad DP1 durch eine Minimalisierungsprozedur gefunden wurden). Da pro Zeitschritt ein Hard-Output-Wert ermittelt werden soll, läuft die Minimierungsprozedur über sämtliche acht neu ermittelten Zustandsmetriken.

Über die Adressverbindung AL2 wird dem Adressdekoder des Datenspeichers RAMW2 die Adresse des Zustandsvektors mit der minimalen Zustandsmetrik zum Zeitschritt k zugeleitet, wodurch über die Datenverbindung DL13 der entsprechende Zustandsvektor aufgerufen wird, welcher, wie bereits beschrieben, aus den Übergangs-Datensymbolen der jeweiligen Vorgänger-Zustände zusammengesetzt ist.

Um die Sicherheit des ausgegebenen Hard-Output-Wertes zu erhöhen, wird eine "Trace-Back"-Operation durchgeführt, das heisst, es wird das um p Zeitschritte zurückliegend entschiedene Übergangs-Datensymbol ausgewählt. Z.B. kann p = 6 gewählt werden.

Es wird darauf hingewiesen, dass p > v möglich ist, das heisst, dass der zeitliche Rückgriff der "Trace-Back"-Operation länger als das für die Berechnung der Übergangsmetriken verwendete Kanalgedächtnis sein kann. In diesem Fall müssen längere Zustandsvektoren bestehend aus entsprechend mehr (mindestens p Stück) PSK-Datensymbolen verwendet werden. Die Neuberechnung eines Zustands erfolgt dann weiterhin wie in Fig. 8 dargestellt, jedoch mit entsprechend längeren Zustandsvektoren. Auf die Berechnung der Übergangsmetriken ist die Verwendung "längerer" Zustandsvektoren ohne Einfluss, da hierbei stets nur die letzten v Datensymbole und das aktuelle Übergangs-Datensymbol berücksichtigt werden.

Die beschriebenen Datenpfade arbeiten Hand in Hand, ohne dass Zwischenberechnungen in dem DSP erforderlich sind. Der DSP dient im wesentlichen lediglich zur Durchführung der Kanalschätzungen und zur Berechnung der Produkte $-h_i*8PSK_j$ (oder allgemein Partialsummanden der Übergangsmetrikwerte bestehend aus einem oder mehreren solcher Produkte) sowie zur Programmierung und Konfiguration der Hardware-Rechenwerke RW1 und RW2. Die eigentliche Rechenprozedur wird jedoch ohne Beteiligung des DSPs durchgeführt, weshalb dieser nur moderaten Leistungsanforderungen (<100 MIPS) genügen muss.

Die bisherige Beschreibung der Arbeitsweise des Rechenwerks RW1 erfolgte am Beispiel einer EDGE-Entzerrung basierend auf 8PSK Datensymbolen. Sämtliche Datenpfade DP1 bis DP6 können jedoch auch für eine GSM-Entzerrung eingesetzt werden. Erforderlich ist hierfür lediglich eine geeignete Umkonfiguration der Datenpfade.

Bei der GSM-Entzerrung wird z.B. ein Kanalgedächtnis der Länge v = 5 zugrunde gelegt, das heisst Kanalkoeffizienten $h_0$, $h_1$, $h_2$, $h_3$, $h_4$, $h_5$ im Rahmen der Kanalschätzung vom DSP ermittelt.

Die Übergangsmetriken $I_k(m \rightarrow m')$ errechnen sich nach folgender Formel:

$$\left| x_k - \sum_{i=0,\ldots,4} h_i * (1 - 2 * a_i) - h_5 * (1 - 2 * a_5) \right|^2, \qquad (4)$$

wobei $a_i$ Bits sind, das heisst $a_i=0,1$ für alle $i=0,1,..,5$.

Es wird ein reduziertes Trellis-Diagramm mit Zuständen der Form $a_1,a_2,a_3,a_4$ betrachtet. Das Übergangs-Bit wird mit $a_0$ bezeichnet, das Bit $a_5$ stellt eine Zusatz-Information zu dem betrachteten Zustand dar, welche lediglich im Rahmen der Berechnung der Übergangsmetriken berücksichtigt wird. Ein Zustandsvektor ist analog zu der in Fig. 1 erläuterten Schreibweise in der Form $a_5$, $a_4$, $a_3$, $a_2$, $a_1$ darstellbar.

Unter diesen Voraussetzungen weist das Trellis-Diagramm zu jedem Zeitschritt $2^4=16$ Zustände auf. Da jeder (Ziel-)Zustand über zwei Übergänge erreicht werden kann, ergeben sich für jeden Zeitschritt 32 mögliche Übergänge.

Der Datenpfad DP2 zur Berechnung der Übergangsmetriken kann aufgrund der identischen Berechnungsvorschrift bei GSM ohne Änderungen eingesetzt werden.

Der Datenpfad DP1 zur Berechnung der ACS-Operationen wird in der Weise umkonfiguriert, dass der temporäre Speicher REG3 sowie die Minimierungsschleife bestehend aus der Minimum-Einheit MIN2, dem temporären Speicher REG4 und dem Multiplexer MUX2 entfallen. Infolgedessen entfällt die Zeiger-Information Z2. Die Zeiger-Information Z=Z1 ist lediglich binär, der Speicher P0 kann überbrückt werden.

Bei dem Datenpfad DP3 zur Berechnung von Soft-Output-Werten braucht lediglich einer der drei Zweige aktiviert zu sein, folglich sind die beiden Multiplexer MUXu und MUXd deaktiviert bzw. überbrückt. Mit dieser Umkonfiguration ist der Datenpfad DP3 für die GSM-Entzerrung nutzbar.

Ebenfalls im GSM-Fall verwendbar sind die in den Fig. 7 und 8 gezeigten Datenpfade. Bei dem Datenpfad DP6 (siehe Fig. 7) ist die Minimierungsschleife über 16 Durchläufe zu führen, in dem in Fig. 8 dargestellten Datenpfad DP4 ist das Schiebe- und Einfüge-Register SHIN weiterhin verwendbar, es muss jedoch die modifizierte Definition des Zustandsvektors berücksichtigt werden. Gleiches gilt für die in Fig. 7 dargestellte Trace-Back-Operation im Datenpfad DP6.

**Patentansprüche**

1. Viterbi-Entzerrer zur Entzerrung einer über einen gestörten Kanal übertragenen Symbolfolge durch Prozessieren eines reduzierten Trellis-Diagramms, in welchem einem Trellis-Zustand eine pfadabhängige Zusatzinformation zugeordnet ist, mit einem digitalen Signalprozessor DSP und

   - einem Hardware-Datenpfad (DP1) zur Durchführung von ACS-Operationen, welcher so ausgelegt ist, daß er Zustandsmetriken von Zielzuständen in dem Trellis-Diagramm für einen betrachteten Zeitschritt berechnet,

- einem dem Hardware-Datenpfad (DP1) zur Durchführung von ACS-Operationen nachgeschalteten Hardware-Datenpfad (DP4) zur Berechnung der pfadabhängigen Zusatzinformation für die Trellis-Zielzustände, und
- einem Hardware-Datenpfad (DP2) zur Berechnung von Übergangsmetriken, welcher so ausgelegt ist, daß er unter Berücksichtigung der Kanaleigenschaften und der berechneten pfadabhängigen Zusatzinformation aus der erhaltenen Symbolfolge Übergangsmetriken von Vorgänger-Zuständen zu Zielzuständen in dem nächsten Zeitschritt des Trellis-Diagramms berechnet.

2. Viterbi-Entzerrer nach Anspruch 1,
   **gekennzeichnet durch**

   - einen Hardware-Datenpfad (DP3), welcher so ausgelegt ist, daß er Soft-Output-Werte für die zu schätzende Symbolfolge aus den zu den Zielzuständen führenden Zustandsübergängen berechnet.

3. Viterbi-Entzerrer nach einem der Ansprüche 1 oder 2,
   **dadurch gekennzeichnet,**

   - **dass** die beiden Hardware-Datenpfade zur Durchführung von ACS-Operationen (DP1) und zur Berechnung von Übergangsmetriken (DP2) und/oder die beiden Hardware - Datenpfade zur Durchführung von ACS-Operationen (DP1) und zur Schätzung von Soft-Output-Werten (DP3) direkt, d.h. ohne eine Zwischenverarbeitung der im jeweils vorgeordneten Hardware-Datenpfad (DP2; DP1) berechneten Daten im digitalen Signalprozessor, miteinander in Verbindung stehen.

4. Viterbi-Entzerrer nach einem der vorhergehenden Ansprüche,
   **dadurch gekennzeichnet,**

   - **dass** die beiden Hardware-Datenpfade zur Durchführung von ACS-Operationen (DP1) und zur Berechnung von Übergangsmetriken (DP2) und/oder die beiden Hardware-Datenpfade zur Durchführung von ACS-Operationen (DP1) und zur Schätzung von Soft-Output-Werten (DP3) zur Durchführung sowohl von Berechnungen nach dem EDGE-Mobilfunkstandard als auch von Berechnungen nach dem GSM-Mobilfunkstandard ausgelegt sind.

5. Viterbi-Entzerrer nach einem der vorhergehenden Ansprüche,
   **gekennzeichnet durch**

   - einen weiteren Hardware-Datenpfad (DP5) des Entzerrers, welcher so ausgelegt ist, daß er aus einer von dem Hardware-Datenpfad (DP4) zur Berechnung der pfadabhängigen Zusatzinformation erhaltenen Zusatzinformation zu einem Trellis-Zielzustand Adressen von Teilsummen der von diesem Trellis-Zielzustand ausgehenden Übergangsmetrikwerte zu Trellis-Zuständen im nachfolgenden Zeitschritt berechnet.

6. Viterbi-Entzerrer nach einem der vorhergehenden Ansprüche,
   **gekennzeichnet durch**

   - einen Hardware-Datenpfad (DP6) des Entzerrers zur Berechnung von entschiedenen Datensymbolen.

7. Viterbi-Entzerrer nach einem der vorhergehenden Ansprüche,
   **dadurch gekennzeichnet,**

   - **dass** der Hardware-Datenpfad (DP1) zur Durchführung von ACS-Operationen

     -- eine erste Minimierungsstufe (MIN1) aufweist, welche so ausgelegt ist, daß sie das Minimum der Summen aus Metrik- und Übergangsmetrikwerten von zumindest zwei Zustandsübergängen bestimmt, und
     -- eine der ersten Minimierungsstufe (MIN1) nachgeschaltete zweite Minimierungsstufe (MIN2, REG4, MUX2) aufweist, welche so ausgelegt ist, daß sie in sequentieller Verarbeitung das Minimum der von der ersten Minimierungsstufe (MIN1) ausgegebenen Summen bestimmt.

8. Viterbi-Entzerrer nach Anspruch 7,
   **dadurch gekennzeichnet,**

- **dass** beide Minimierungsstufen (MIN1, MIN2) ausgelegt sind, Zeigerinformation (Z1, Z2) auszugeben, und
- **dass** die Zeigerinformationen (Z1, Z2) dem Hardware-Datenpfad (DP4) zur Berechnung der Zusätzinformation zu einem Trellis-Zielzustand zugeführt werden.

9. Viterbi-Entzerrer nach Anspruch 1,
   **dadurch gekennzeichnet,**

   - **dass** der Hardware-Datenpfad (DP2) zur Berechnung von Übergangsmetriken eine Rechenschleife (ADD1, ACCU1, REG1) zur Summation von Produkten für oder Teilsummen von Übergangsmetrikwerten aufweist.

10. Viterbi-Entzerrer nach Anspruch 9,
    **dadurch gekennzeichnet,**

    - **dass** die Rechenschleife (ADD1, ACCU1, REG1) einen temporären Speicher (REG1) zur Abspeicherung einer Teilsumme aufweist, wobei die Teilsumme für die Berechnung sämtlicher Übergangsmetrikwerte von einem bestimmten Vorgänger-Zustand verwendbar ist.

11. Viterbi-Entzerrer nach Anspruch 9 oder 10,
    **dadurch gekennzeichnet,**

    - **dass** der Hardware-Datenpfad (DP2) zur Berechnung von Übergangsmetriken wenigstens eine der Rechenschleife nachgeschaltete Quadriererstufe (rQUAD) sowie wenigstens eine weitere Addiererstufe (ADD2) aufweist.

12. Viterbi-Entzerrer nach Anspruch 2,
    **dadurch gekennzeichnet,**

    - **dass** der Hardware-Datenpfad (DP3) zur Berechnung von Soft-Output-Werten wenigstens eine Rechenschleife aufweist, die eine Minimum-Einheit (MIN3-5), einen Demultiplexer (DMUX1-3), zwei ausgangsseitig des Demultiplexers (DMUX1-3) angeordnete Speicher (REG5-10) und einen Multiplexer (MUX3-5) aufweist, wobei die Ausgänge der beiden Speicher (REG5-10) über den Multiplexer (MUX3-5) einem Eingang der Minimum-Einheit (MIN3-5) zugeführt sind.

**Claims**

1. Viterbi equalizer for equalization of a symbol sequence which is transmitted via a channel that is subject to interference by processing of a reduced trellis diagram in which path-dependent additional information is allocated to each trellis state, having a digital signal processor DSP, and

   - a hardware data path (DP1) for carrying out ACS operations, which is designed such that it calculates state metrics of destination states in the trellis diagram for a time step under consideration,
   - a hardware data path (DP4), which is connected downstream from the hardware data path (DP1) for carrying out ACS operations, in order to calculate the path-dependent additional information for the trellis destination states, and
   - a hardware data path (DP2) for calculation of branch metrics, which is designed such that, taking into account the channel characteristics and the calculated path-dependent additional information, it uses the received symbol sequence to calculate branch metrics from predecessor states to destination states in the next time step in the trellis diagram.

2. Viterbi equalizer according to Claim 1,
   **characterized by**

   - an associated hardware data path (DP3), which is designed such that it calculates soft output values for the symbol sequence to be estimated from the state transitions which lead to the destination states.

3. Viterbi equalizer according to one of Claims 1 or 2,
   **characterized**

- **in that** the two hardware data paths for carrying out ACS operations (DP1) and for calculation of branch metrics (DP2) and/or the two hardware data paths for carrying out ACS operations (DP1) and for estimation of soft output values (DP3) are connected directly to one another, that is to say without any intermediate processing in the digital signal processor of the data calculated in the respective upstream hardware data path (DP2; DP1).

4. Viterbi equalizer according to one of the preceding claims,
   **characterized**

   - **in that** the two hardware data paths for carrying out ACS operations (DP1) and for calculation of branch metrics (DP2) and/or the two hardware data paths for carrying out ACS operations (DP1) and for estimation of soft output values (DP3) are designed to carry out not only calculations in accordance with the EDGE mobile radio standard, but also calculations in accordance with the GSM mobile radio standard.

5. Viterbi equalizer according to one of the preceding claims,
   **characterized by**

   - a further hardware data path (DP5) of the equalizer which is designed such that it uses additional information obtained from the hardware data path (DP4) for calculating the path-dependent additional information to a trellis destination state to calculate addresses of partial sums of the branch metrics values which originate from this trellis destination state to trellis states in the next time step.

6. Viterbi equalizer according to one of the preceding claims,
   **characterized by**

   - a hardware data path (DP6) of the equalizer for calculation of determined data symbols.

7. Viterbi equalizer according to one of the preceding claims,
   **characterized**

   - **in that**, in order to carry out ACS operations, the hardware data path (DP1)

     -- has a first minimization stage (MIN1) which determines the minimum of the sums from metrics and branch metrics values of at least two state transitions, and
     -- has a second minimization stage (MIN2, REG4, MUX2), which is connected downstream from the first minimization stage (MIN1) and which is designed such that, by sequential processing, it determines the minimum of the sums emitted by the first minimization stage (MIN1).

8. Viterbi equalizer according to Claim 7,
   **characterized**

   - **in that** both minimization stages (MIN1, MIN2) are designed to emit pointer information (Z1, Z2), and
   - **in that** the pointer information (Z1, Z2) is passed to the hardware data path (DP4) in order to calculate the additional information relating to a trellis destination state.

9. Viterbi equalizer according to Claim 1,
   **characterized**

   - **in that** the hardware data path (DP2) for calculation of branch metrics has a calculation loop (ADD1, ACCU1, REG1) for summation of products for or partial sums from branch metrics values.

10. Viterbi equalizer according to Claim 9,
    **characterized**

    - **in that** the calculation loop (ADD1, ACCU1, REG1) has a temporary memory (REG1) for storage of a partial sum, in which case the partial sum can be used for the calculation of all the branch metrics values from a specific previous state.

11. Viterbi equalizer according to Claim 9 or 10,

**characterized**

- **in that** the hardware data path (DP2) for calculation of branch metrics has at least one squaring stage (rQUAD), which is connected downstream from the calculation loop, as well as at least one further addition stage (ADD2).

**12.** Viterbi equalizer according to Claim 2,
   **characterized**

- **in that** the hardware data path (DP3) for calculation of soft output values has at least one calculation loop, which has a minimum unit (MIN3-5), a demultiplexer (DMUX1-3), two memories (REG5-10) which are arranged on the output side of the demultiplexer (DMUX1-3), and a multiplexer (MUX3-5), in which case the outputs of the two memories (REG5-10) can be supplied via the multiplexer (MUX3-5) to one input of the minimum unit (MIN3-5) .

**Revendications**

**1.** Égalisateur de Viterbi pour égaliser une suite de symboles transmise par un canal perturbé par traitement d'un diagramme de Trellis réduit, dans lequel une information supplémentaire en fonction du chemin est associée à un état de Trellis, comprenant un processeur DSP numérique du signal et

- un chemin (DP1) de données en matériel pour effectuer des opérations ACS, qui est conçu de manière à calculer des métriques d'états de destination dans le diagramme de Trellis pour un pas temporel considéré ;
- un chemin (DP4) de données en matériel, monté en aval du chemin (DP1) de données en matériel pour l'exécution d'opérations ACS, afin de calculer l'information supplémentaire en fonction du chemin pour les états de destination de Trellis ; et
- un trajet (DP2) de données en matériel pour calculer des métriques de transition, qui est conçu pour calculer, en tenant compte des propriétés de canal et de l'information supplémentaire en fonction du chemin calculée à partir de la suite de symboles obtenue, des métriques de transition d'états précurseurs à des états de destination dans le pas temporel venant immédiatement ensuite du diagramme de Trellis.

**2.** Égalisateur de Viterbi suivant la revendication 1,
   **caractérisé par**

- un chemin (DP3) de données en matériel, qui est conçu pour calculer des valeurs de sortie logicielles pour la suite de symboles à évaluer à partir des transitions d'états menant aux états de destination.

**3.** Égalisateur de Viterbi suivant l'une des revendications 1 ou 2,
   **caractérisé**

- **en ce que** les deux trajets de données en matériel pour exécuter des opérations (DP1) d'ACS et pour le calcul de métriques (DP2) de transition et/ou les deux chemins de données en matériel pour effectuer des opérations (DP1) ACS et pour évaluer des valeurs (DP3) de sortie logicielles sont reliés directement entre eux, c'est-à-dire sans un traitement intermédiaire dans le processeur numérique du signal des données calculées dans le chemin (DP2, DP1) de données en matériel, respectivement, en amont.

**4.** Égalisateur de Viterbi suivant l'une des revendications précédentes,
   **caractérisé**

- **en ce que** les deux chemins de données en matériel pour exécuter des opérations (DP1) d'ACS et pour calculer des métriques (DP2) de transition et/ou les deux chemins de données en matériel pour exécuter des opérations (DP1) d'ACS et pour évaluer des valeurs (DP3) de sortie logicielles sont conçus pour exécuter tant des calculs suivant la norme de téléphonie mobile EDGE qu'également des calculs suivant la norme de téléphonie mobile GSM.

**5.** Égalisateur de Viterbi suivant l'une des revendications précédentes,
   **caractérisé par**

- un autre chemin (DP5) de données en matériel de l'égaliseur, qui est conçu pour à calculer dans le pas temporel suivant à partir d'une information supplémentaire sur un état de destination de Trellis, obtenue à partir du chemin (DP4) de données en matériel pour le calcul de l'information supplémentaire en fonction du chemin, des adresses de sous-sommes des valeurs de métriques de transition vers des états de Trellis en partant de cet état de destination de Trellis.

6. Égaliseur de Viterbi suivant l'une des revendications précédentes,
   **caractérisé par**

- un chemin (DP6) de données en matériel de l'égaliseur pour le calcul de symboles de données déterminants.

7. Égaliseur de Viterbi suivant l'une des revendications précédentes,
   **caractérisé**

- **en ce que** le chemin (DP1) de données en matériel pour exécuter des opérations d'ACS

   -- a un premier étage (MIN1) de minimisation, qui est conçu pour déterminer un minimum des sommes constituées de valeurs de métriques et de valeurs de métriques de transition d'au moins deux transitions d'états ; et
   -- a un deuxième étage (MIN2, REG4, MUX2) de minimisation en aval du premier étage (MIN1) de minimisation, qui est conçu pour déterminer en traitement séquentiel le minimum des sommes émises par le premier étage (MIN1) de minimisation.

8. Égaliseur de Viterbi suivant la revendication 7,
   **caractérisé**

- **en ce que** les deux étages (MIN1, MIN2) de minimisation sont conçus pour émettre des informations (Z1, Z2) de pointeur ; et
- **en ce que** les informations (Z1, Z2) de pointeur sont envoyées au chemin (DP4) de données en matériel pour calculer l'information supplémentaire sur un état de destination de Trellis.

9. Égaliseur de Viterbi suivant la revendication 1,
   **caractérisé**

- **en ce que** le chemin (DP2) de données en matériel a, pour le calcul de métriques de transition, une boucle (ADD1, ACCU1, REG1) de calcul pour sommer des produits ou des sous-sommes de valeurs de métriques de transition.

10. Égaliseur de Viterbi suivant la revendication 9,
    **caractérisé**

- **en ce que** les boucles (ADD1, ACCU1, REG1) de calcul ont une mémoire (REG1) temporaire de mémorisation d'une sous-somme, la sous-somme pouvant être utilisée pour le calcul de l'ensemble des valeurs de métriques de transition d'un état précurseur déterminé.

11. Égaliseur de Viterbi suivant la revendication 9 ou 10,
    **caractérisé**

- **en ce que** le chemin (DP2) de données en matériel a, pour le calcul de métriques de transition, au moins un étage (rQUAD) d'élévation au carré en aval de la boucle de calcul ainsi qu'au moins un autre étage (ADD2) d'addition.

12. Égaliseur de Viterbi suivant la revendication 2,
    **caractérisé**

- **en ce que** le chemin (DP3) de données en matériel a, pour le calcul de valeurs de sortie logicielles, au moins une boucle de calcul qui a une unité (MIN3-5) de minimum, un démultiplexeur (DMUX1-3), deux mémoires (REGS-10) montées du côté sortie du démultiplexeur (DMUX1-3), les signaux de sortie des deux mémoires (REGS-10) étant envoyés par l'intermédiaire du multiplexeur (MUX3-5) à une entrée de l'unité (MIN3-5) de minimum.

empfangenes Datensymbol $x_k$

Zustandsvektor

$PSKi_4,..., PSKi_0, \underline{PSK0}$ [0]

$........................, \underline{PSK1}$ [1]

$........................, \underline{PSK2}$ [2]

$........................, \underline{PSK3}$ [3]

$PSKii_4,..., PSKii_0, \underline{PSK4}$ [4]

$........................, \underline{PSK5}$ [5]

$........................, \underline{PSK6}$ [6]

$PSKiii_4,..., PSKiii_0, \underline{PSK7}$ [7]

Zusatz-Information — Zustand

k - 1

k

[0]
[1]
[2]
[3]
[4]
[5]
[6]
[7]

neuer Zustandsvektor

$PSKii_3,..., PSKii_0, PSK4, \underline{PSK1}$

Zusatz-Information

**Fig.1**

DL6

ZS1

DP2

$x_k$,

$-h_i * PSK_j$

$i=0,...,6$

DL1.1/2

ADD1

ACCU1

rQUAD

ADD2

SH1

MUX0

0

REG1

kQUAD

**Fig.4**

Fig.2

Fig.3

EP 1 297 668 B1

$M_{k-1}(0)$ DL5

DP1

0

DL10

ADD3

ADD4

REG2

MIN1

REG3

MIN2

REG4

MUX1

$M_{k-1}(1)$

$I_k(0→1)$

DL3

MUX2

0x7FFF

DL7

DL12

Z1

Z2

$I_k(1→1)$

PO

DP6

Z(Z1,Z2)

Fig.5

DP4

Z(Z1,Z2)

DL8

DL11

SHIN

0 0 1

| l | k | j | i | h | g | f | e | d | c | b | a | 1 | 0 | 0 | 0 | 0 | 1 |

DL9

| o | n | m | i | k | j | i | h | g | f | e | d | c | b | a | 1 | 0 | 0 |

Fig.8

Fig.6

Fig.7